# EUROPEAN PATENT SPECIFICATION

(11) **EP 4 307 352 B1**
(45) Date of publication and mention of the grant of the patent: **07.05.2025**
(21) Application number: 22836031.9
(22) Date of filing: 29.06.2022
(51) Int. Cl.: H01L 21/66, H01L 23/00

(54) **PACKAGING STRUCTURE, MANUFACTURING METHOD THEREFOR AND SEMICONDUCTOR DEVICE**
GEHÄUSESTRUKTUR, DAFÜR VORGESEHENES HERSTELLUNGSVERFAHREN UND HALBLEITERBAUELEMENT
STRUCTURE DE BOÎTIER, PROCÉDÉ DE FABRICATION ASSOCIÉ ET DISPOSITIF À SEMI-CONDUCTEUR

(30) Priority: 01.06.2022 CN 202210619084
(43) Date of publication of application: 17.01.2024
(73) Proprietor: Changxin Memory Technologies, Inc., Hefei, Anhui 230601 (CN)
(72) Inventor: TIAN, Kai, Hefei, Anhui 230601 (CN); LI, Hongwen, Hefei, Anhui 230601 (CN); QUAN, Changhao, Hefei, Anhui 230601 (CN); CHEN, Liang, Hefei, Anhui 230601 (CN); WANG, Yuxia, Hefei, Anhui 230601 (CN); GUO, Yingdong, Hefei, Anhui 230601 (CN)
(74) Representative: Lavoix
(86) International application number: PCT/CN2022/102515
(87) International publication number: WO 2023/231122

(56) References cited:
- CN-A- 105 548 851
- CN-A- 106 920 797
- CN-A- 107 424 970
- CN-A- 112 582 365
- CN-A- 112 864 130
- US-A1- 2002 180 026
- US-A1- 2007 090 356
- US-A1- 2010 314 619

## Description

### TECHNICAL FIELD

The invention relates to the technical field of semiconductors, in particular to a package structure, a method for manufacturing the same and a semiconductor device.

### BACKGROUND

With the rapid increase of the popularity of electronic equipment and the vigorous development of the electronic equipment market, it is increasingly required that electronic products should be miniaturized and thinned while having high performance, multifunction, high reliability and convenience. The demands require better, lighter, thinner, higher packaging density, better electrical and thermal properties, higher reliability and higher cost performance of semiconductor devices.

In order to ensure the performance of semiconductor devices to meet the corresponding requirements, it is necessary to prepare ports on the package structure for testing and performing functional interaction.

US 2007/090356 A1 discloses a semiconductor device, including: a semiconductor substrate having an electrode; a resin layer provided on the surface of the semiconductor substrate on which the electrode is formed and having a concave portion formed on a second surface on the other side of a first surface facing the semiconductor substrate; a test pad electrically connected to the electrode and formed inside the concave portion; wiring electrically connected to the test pad, going through on the second surface of the resin layer, and narrower in width than the test pad; and a land electrically connected to the test pad and having an external terminal formed thereon.

US 2002/180026 A1 discloses a semiconductor wafer designed to avoid probed marks while testing, the semiconductor wafer designed to avoid probed marks while testing includes: a plurality of semiconductor chips, each chip having an integrated circuit forming surface formed on the same plane of the semiconductor wafer, wherein the chip has a plurality of bonding pads on the integrated circuit forming surface; a plurality of cutting paths, each cutting path being formed between two adjoining chips; a plurality of metal interconnects being on the integrated circuit forming surface of the chip and electrically connecting with the corresponding bonding pad respectively; a passivation layer covering the plurality of the metal interconnects and having a plurality of the first openings and the second openings; a plurality of test pads located at the first openings of the passivation layer and connecting to the corresponding bonding pad through a corresponding metal interconnect; and a plurality of contact pads being located at the second opening of the passivation layer, wherein the contact pad is connected in series with corresponding metal interconnect between the corresponding bonding pad and test pad.

### SUMMARY

In view of this, in order to solve one or more of the related technical problems, embodiments of the disclosure provides a package structure, a method for manufacturing the same, and a semiconductor device.

The present disclosure provides a package structure, a manufacturing method therefor and a semiconductor device as defined in the appended claims 1-13.

In various embodiments of the disclosure, N first pads are provided in a top metal layer to perform a test on the semiconductor functional structure at a first operating speed. Some first pads are arranged side by side along a first direction near a first edge of the semiconductor functional structure. Other first pads are arranged side by side along the first direction near a second edge of the semiconductor functional structure. After the test at the first operating speed is completed, the second pads corresponding to the first pads one by on are provided in the redistribution layers on the first pads to perform a test on the semiconductor functional structure at a second operating speed. A relative position between the second pad and the third pad for some redistribution layers is different from a relative position between the second pad and the third pad for other redistribution layers. A center point of the second pad is offset in a same direction and is offset by an equal distance relative to a center point of a corresponding first pad for all the second pads; by doing so, the N first pads and the N second pads keep a same relative position. Meanwhile, relative positions between the second pads and the third pads located at different edges are different; by doing so, the redistribution layers located at the two edges can keep a large fault tolerance rate, and can all be close to the edges but not beyond the edges. Therefore, the first pads and the second pads are ensured to be in favorable positions which are beneficial to saving a total area, and meanwhile, a same set of probe cards may be used for tests at the two different operating speeds. Compared with using two sets of probe cards to test separately, test cost and time are saved, and production cycle and manufacturing cost are reduced.

### BRIEF DESCRIPTION OF THE DRAWINGS

FIG. 1 is a cross-sectional schematic diagram of a package structure provided in an example not forming part of the present invention but useful for understanding it.
FIG. 2A is a cross-sectional schematic diagram of another package structure provided in embodiments of the disclosure.
FIG. 2B is a top view schematic diagram of FIG. 2A.
FIG. 2C is a cross-sectional schematic diagram of a package structure with a conductive pillar provided in embodiments of the disclosure.
FIG. 3 is a schematic diagram of a relative position of first pads and second pads provided in embodiments of the disclosure.
FIG. 4 is a schematic diagram of a relative position of the second pads and third pads provided in embodiments of the disclosure.
FIG. 5 is a flowchart of a method for manufacturing a package structure provided in embodiments of the disclosure.
FIG. 6A to FIG. 6D are schematic diagrams of a process for manufacturing a package structure provided in embodiments of the disclosure.

### Description of reference numerals

101-top metal layer; 102-first type pad; 103-redistribution layer; 104-second type pad; 105-third type pad; 200-semiconductor functional structure; 201-semiconductor functional layer; 202-interconnect layer; 203-isolation layer; 204-via hole; 205-first pad; 2051- first part of first pad; 2052- second part of first pad; 2051a-first end of first pad; 2052a-third end of first pad; 206-redistribution layer; 206a-second end of redistribution layer; 206b-fourth end of redistribution layer; 207-conductive pillar; 208-first insulating layer; 209-groove; 210-second insulating layer; 211-second pad; 212-third pad; 213-first region; 600-semiconductor functional structure; 601-semiconductor functional layer; 602-interconnect layer; 603-isolation layer; 604-via hole; 605-first pad; 606-redistribution layer; 608-first insulating layer; 609-groove; 610-second insulating layer; 611-second pad; 612-third pad.

In the above figures (which are not necessarily drawn to scale), similar reference numerals may describe similar components in different views. Similar reference numerals with different letter suffixes may represent different examples of similar components. The accompanying drawings generally illustrate the various embodiments discussed herein by way of example and not limitation.

### DETAILED DESCRIPTION

The technical solution of the disclosure will be further explained in detail below with reference to the drawings and embodiments. Although exemplary embodiments of the disclosure are shown in the drawings, it is to be understood that the disclosure may be embodied in various forms and should not be limited by the embodiments set forth herein. On the contrary, these embodiments are provided to enable a more thorough understanding of the disclosure.

The embodiments of the disclosure are described in more detail by way of example in the following paragraphs with reference to the drawings. The advantages and features of the disclosure will become more apparent from the following description and the claims. It is to be noted that the drawings are provided in a very simplified form with inaccurate proportions to illustrate the purposes of the embodiments of the disclosure in a convenient and clear way.

It is understood that the meanings of "on", "up" and "above" of the disclosure should be interpreted in the widest manner, so that "on" not only means its meaning of "on" something "without intervening features or layers (that is, directly on something), but also includes" on "something with intervening features or layers.

In the embodiments of the disclosure, a term "A is connected to B" includes a case where A and B are in direct contact, or a case where A and B are in indirect contact through an intermediate conductive structure. Terms "first", "second", and so on are used to distinguish similar objects and need not be used to describe a particular order or priority.

In the embodiments of this disclosure, a term "layer" refers to a portion of an object that includes a region having a thickness. The layer may extend on a lower surface or an upper surface of the structure, and its area may be less than or equal to an area of the extended surface on which the layer lies. It is to be noted that the technical solution described in the embodiments of this disclosure can be arbitrarily combined without conflict.

A semiconductor functional structure involved in the embodiments of the disclosure is a part that will be used in a subsequent manufacturing process to form a final semiconductor device, and is a core part to realize main functions of the semiconductor device. The final semiconductor device may include, but is not limited to, a memory.

In a design of a package structure of a semiconductor device, such as a DRAM (Dynamic Random Access Memory), there are two modes to set pads: one is to window on a top metal; the other is to window on redistribution layers (RDL, Redistribution Layer).

Windowing on a top metal means that a passivation layer or an insulating layer is formed on a top metal layer of a semiconductor functional structure to protect the semiconductor functional structure from being broken. Then window regions are formed on the passivation layer or the insulating layer to expose parts of the top metal layer to form pads. A probe card test may be carried out on the pads, to test electrical performances of the semiconductor functional structure. A bonding wire may also be leaded out from the pad to realize electrical leading out of the semiconductor functional structure.

Windowing on redistribution layers means that a redistribution layers are formed on the top metal layer of the semiconductor functional structure. A passivation layer or an insulating layer is formed on the redistribution layers, and then windowing regions are formed on the passivation layer or the insulating layer, so as to expose parts of each of the redistribution layers and form two pads arranged side by side. One of the two pads is used for carrying out the punch needles test of probe card, and the other is used for leading out the bonding wires on the pads. The redistribution layers may play a role in adjusting positions of the pads in the semiconductor device, and may also play a role in strengthening power supply network of power ground.

It is to be understood that, the top metal layer is relatively thin, and there is a gasket structure below. As such, it is possible to run a probe card test and then bonding wire package is conducted in a packaging factory at the same windowing metal region, without affecting a yield of a wire bond package. Generally, a material of the redistribution layer is a metal. The redistribution layer is thicker than the top metal layer, and deep and rough marks will be resulted by a probe card test. The marks will affect the yield of the wire bond package. Therefore, in the redistribution layer, the pad for testing and is required to be distinguished from the pad for leading out bonding wires. No matter which of the above windowing modes is adopted in the package structure, there is no great influence on the function of the semiconductor device. Redistribution layer windowing is beneficial to improve performance, but the production cycle and production cost are increased.

In related art, generally, one of the above two windowing modes is selected to design a package structure according to an actual need of semiconductor device. However, in practical applications, there may be various needs, rather than a single one in a production process of the semiconductor devices. Examples of needs are given below:

For example, before a mass production of semiconductor devices (or "products"), there is a long process of functional debugging. During the debugging process, a test is conducted in a state where the operating speed of the semiconductor functional structures is low. At this stage, the top metal layer windowing mode is enough to achieve the packaging and testing of the semiconductor functional structures. However, when the debugging process is ended, the semiconductor functional structures need to be tested at a high operating speed state, it is necessary to adopt the redistribution layer windowing mode for the packaging test.

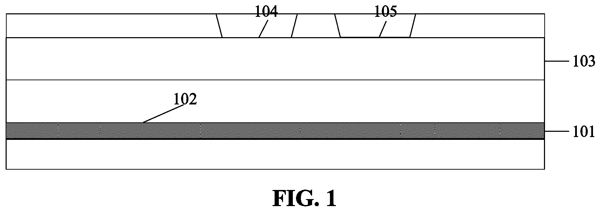

Based on the above, embodiments of the disclosure provide a package structure. Referring to FIG. 1, which shows an example not forming part of the present invention but useful for understanding it, the package structure includes the mode of windowing on a top metal and the mode of windowing on redistribution layers. In the mode of opening windows on the top metal, a first type pad 102 is arranged in a top metal layer 101. The first type pad 102 may be used to perform a test at a low speed and lead out a bonding wire. In the mode of opening windows on the redistribution layers, there are two types of pads (a second type pad 104 and a third type pad 105) in a redistribution layer 103, the second type pad 104 is used to perform a test at a high speed, and the third type pad 105 is used to lead out a bonding wire.

On one hand, when performing the test at low speed with the first type pad 102, a probe card for the test needs to hit center points of all the first type pads 102. When performing the test at high speed with the second type pad 104, the probe card for the test needs to hit center points of all the second type pads 104. However, it can be seen from FIG. 1 that the first type pad 102 and the second pad 104 are in different layers of the package structure and that relative positions of the first type pad 102 and the second pad 104 in the different layers are different. For these reasons, in order to meet the requirements of the test at the low speed and the test at the high speed, two sets of test probe cards have to be made, which greatly increases test cost and test time.

On another hand, when there are a large number of test points, not all the first type pads 102 may be placed near one edge of the semiconductor functional structure. In this case, it is necessary to provide the first type pads at two opposite edges of the semiconductor functional structure. Accordingly, the redistribution layers 103 are also required to be provided at the opposite two edges of the semiconductor functional structure. However, since an area occupied by the second type pad 104 and the third type pad 105 together is larger than an area occupied by the first type pad 102, a redistribution layer103 at a position of at least one of the edges is prone to extend beyond the edge.

Based on this, in order to further solve the above problems, the embodiments of the disclosure provide a package structure, a method for manufacturing the same and a semiconductor device. The package structure includes: an isolation layer having a plurality of via holes, N first pads, N redistribution layers, a first insulating layer, second pads and third pads. The isolation layer covers a surface of an interconnect layer. The via holes expose parts of the interconnect layer, and the top surface of the interconnect layer serves as the top surface of the semiconductor functional structure. Each of the N first pads is formed by the interconnect layer exposed by a corresponding via hole. The N is a positive integer greater than 1. Each of the N redistribution layers covers the isolation layer and is electrically connected with a corresponding one of the N first pads. Some first pads are arranged side by side along a first direction near a first edge of the semiconductor functional structure. Some other first pads are arranged side by side along the first direction near a second edge of the semiconductor functional structure. The first edge and the second edge are two opposite edges of the semiconductor functional structure. The first insulating layer covers and exposes parts of each of the redistribution layers. The exposed parts of each of the redistribution layers form a second pad and a third pad. Both an offset direction and an offset distance between a center point of a second pad and a center point of a corresponding first pad are same for all the second pads. A relative position between a second pad and a third pad for some the redistribution layers is different from a relative position between a second pad and a third pad in other redistribution layers. The first pads and the second pads are used for testing the semiconductor functional structure at different operating speeds. The third pads are used for performing functional interaction corresponding to a content tested by the second pads.

It is to be noted that, the first direction referred to in the embodiments of the disclosure is parallel to the surface of the semiconductor functional structure, the second direction referred to in the embodiments of the disclosure is parallel to the semiconductor functional structure and perpendicular to the first direction, and a third direction referred to in the embodiments of the disclosure is perpendicular to both the first direction and the second direction. In some embodiments, the first direction may be parallel to the X-axis direction, the second direction may be parallel to the Y-axis direction, and the third direction may be parallel to the Z-axis direction.

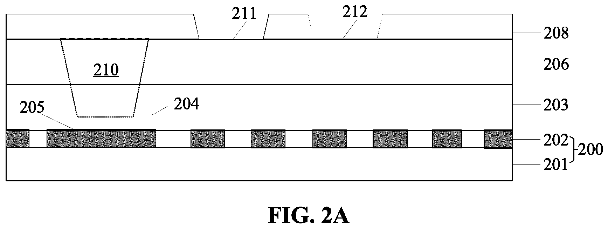

Referring to FIG. 2A, the package structure includes a substrate (not shown in FIG. 2A). A material for forming the substrate may include silicon (Si), germanium (Ge), silicon germanium (SiGe), silicon on insulator (SOI), or germanium on insulator (GOI).

A semiconductor functional structure 200 is located on the substrate. Specifically, the semiconductor functional structure 200 includes a semiconductor functional layer 201 and a interconnect layer 202 located on a surface of the semiconductor functional layer 201. In the semiconductor functional layer 201, a plurality of functional structures may be provided according to actual needs. Accordingly, the interconnect layer 202 is used to lead out electrical signals of the functional structures in the semiconductor functional layer 201 to make the functional structures work. In some embodiments, the interconnect layer 202 includes a top metal layer, not only for leading out the electrical signals from the functional structure but also for supporting the semiconductor functional structure 200.

It is to be noted that, all signals connected to the redistribution layers formed in a subsequent process are connected to the interconnect layer 202, which ensures the function of the semiconductor functional structure 200 even without the redistribution layers. FIG. 2A is a cross-sectional view where part of the interconnect layer 202 has been removed. In practice, parts in the interconnect layer are not truncated, but interconnected, that is, the parts in the interconnect layer may be continuous on other sections.

An isolation layer 203 covers a surface of the interconnect layer 202, and is configured for isolating the interconnect layer 202 and the subsequently formed redistribution layer 206 in part of a region. A via hole 204 is provided in the isolation layer 203, and the via hole 204 exposes part of the interconnect layer 202. A shape of the via hole 204 may be cylindrical or inverted trapezoidal or any suitable shape. A material for forming the isolation layer 203 includes, but is not limited to, tetraethyl orthosilicate (TEOS).

A first pad 205 is formed by the interconnect layer 202 exposed by one of the via holes 204. A plurality of via holes 204 are included within the isolation layer 203, such that a plurality of first pads 205 are formed by the exposure of the plurality of via holes 204. The first pads 205 are used for a first type test. On another hand, in an example not forming part of the present invention but useful for understanding, the first pads 205 can also be used to achieve functional interaction corresponding to a content of the first type test.

Illustratively, the first type test may be understood as some tests performed on the semiconductor functional structure at a lower operating speed. It is to be noted that, in a memory, an operating speed refers to a read-write speed of the memory. The achievement of the functional interaction corresponding to the content of the first type test may be understood as leading out bonding wires on the first pads. That is, when performing the first type test, the first pads 205 can be used to contact a probe card, and a plurality of probes in the probe card correspond to the N first pads one by one, so as to realize electrical connections between the interconnect layer and other test systems.

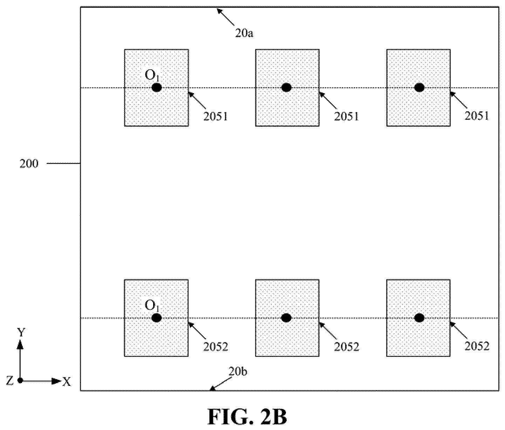

In practical application, when there are a large number of test points, not all the first pads 205 are placed near one edge of the semiconductor functional structure. In this case, the first pads 205 are arranged at two opposite edges of the semiconductor functional structure. Referring to FIG. 2B, there are the N first pads 205. The N first pads are divided into two parts, namely first part of the first pads 2051 and second part of the first pads 2052. The first part of the first pads 2051 includes M1 first pads, and the M1 first pads are arranged side by side along the first direction near a first edge 20a of the semiconductor functional structure. The second part of the first pads 2052 includes M2 first pads, and the M2 first pads are arranged side by side along the first direction near a second edge 20b of the semiconductor functional structure. The first edge 20a and the second edge 20b are two opposite edges of the semiconductor functional structure. Here, M1+M2 = N.

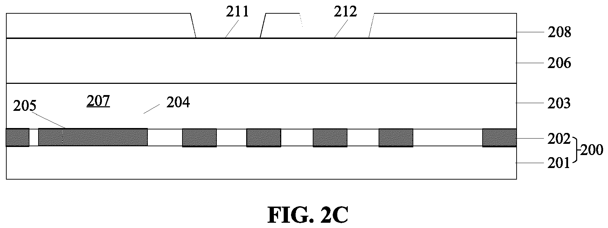

It is to be noted that, FIG. 2A is a partial cross-sectional schematic diagram of a package structure where the first pad 205 is in direct contact with a redistribution layer 206. FIG. 2B is a top view of an example of a package structure, in which other layers are omitted in order to show a position arrangement of the first pads more clearly in FIG. 2B. FIG. 2C is a partial cross-sectional schematic diagram of a package structure where a first pad 205 is in indirect contact with a redistribution layer 206 through a conductive pillar 207.

In some embodiments, the number of first pads in the first part of the first pads 2051 and that in the second part of the first pads 2052 may be the same or different.

Specifically, the six first pads in FIG. 2B are divided into the first part of the first pads 2051 and the second part of the first pads 2052. The first part of the first pads 2051 includes three first pads arranged side by side along the first direction near the first edge 20a of the semiconductor functional structure. The second part of the first pads 2052 includes three first pads arranged side by side along the first direction near the second edge 20b of the semiconductor functional structure.

Referring to FIG. 2A, there are N redistribution layers 206 located on the surface of the isolation layer 203 and at the via holes 204. Each of the redistribution layers 206 covers the isolation layer 203. A redistribution layer 206 is in direct contact with the corresponding one of the N first pads 205.

The redistribution layer 206 can contact the first pad 205 in both a direct manner (FIG. 2A) and an indirect manner (i.e., a conductive material layer such as a conductive pillar 207 is provided between the redistribution layer 206 and the first pad 205, FIG. 2B and FIG. 2C). A material for forming the conductive pillar 207 may be the same as or different from that of the redistribution layer 206. It is to be noted that a height of the conductive pillar 207 may be less than or equal to a depth of the via hole 204. The height of the conductive pillar 207 shown in FIG. 2C is equal to the depth of the via hole 204.

In some embodiments, the package structure includes conductive pillars 207. There are a plurality of conductive pillars, and the plurality of conductive pillars are arranged side by side along the first direction.

In the embodiments described above, there may be one or more conductive pillars 207 within a same via hole 204. Adjacent ones of the conductive pillars 207 are isolated by an insulating material. Accordingly, conductive pillars 207 correspond to the first pads 205 one by one, that is, where there are a plurality of conductive pillars 207 in a same via hole 204, there are a plurality of first pads 205 at a bottom of the same via hole 204.

It is to be understood that, when there are a plurality of conductive pillars 207, all the plurality of conductive pillars 207 are connected to a corresponding redistribution layer 206 and the interconnect layer 202, so that the reliability of the electrical connection between the redistribution layer 206 and the interconnect layer 202 can be increased.

It is to be understood that, by providing the plurality of first pads 205 without changing bottom area of the via hole, it is beneficial to reduce total area of all the first pads 205 at the bottom of the same via hole 204, thereby reducing a parasitic capacitance between the first pads 205 and a surrounding conductive material, and further optimizing a signal transmission performance.

Referring to FIG. 2A, a first insulating layer 208 is located on the redistribution layer 206.

The first insulating layer 208 covers a surface of the redistribution layer 206. A redistribution layer 206 on an exposed part of the interconnect layer 202 may have a same thickness as the redistribution layer 206 on the surface of the isolation layer 203. In some embodiments, where a diameter of the via hole 204 is two times greater than a thickness of the redistribution layer 206. The redistribution layer 206 covers a sidewall and the bottom of the via hole 204, and surrounds a groove 209.

In some embodiments, referring to FIG. 2A, the redistribution layer 206 is in direct contact with the corresponding first pad 205. The package structure further includes a second insulating layer 210 located within the groove 209 surrounded by each of the redistribution layers. Hardness of a material of the second insulating layer 210 is less than hardness of the material of the redistribution layer 206. By doing so, on one hand, a stress of the package structure can be reduced and the reliability of the package structure can be increased. On another hand, compared with filling the groove 209 with the redistribution layer 206, filling the groove 209 with the material of the second insulating layer 210 can avoid generating more parasitic capacitance.

In some embodiments, the second insulating layer 210 and the first insulating layer 208 may be an integral structure or separate structures. When the two are of separate structures, the materials of the two may be different. FIG. 2A shows a case where the second insulating layer 210 and the first insulating layer 208 are of an integral structure. The material for forming the second insulating layer 210 includes, but is not limited to, polyimide (PI).

Referring to FIG. 2A, at least some of the N redistribution layers 206include second pads 211 and third pads 212 at the exposed parts.

Here, a second pad 211 and a third pad 212 are provided in each of the N redistribution layers 206. In other words, N second pads 211 correspond to N third pads 212 one by one. The second pads 211 are used for a second type test, and the third pads 212 are used for achieving functional interaction corresponding to a content of the second type test. The second type test may be understood as some tests performed on the semiconductor functional structure at a higher operating speed. The achievement of the functional interaction corresponding to the content of the second type test may be understood as leading out bonding wires on the third pads and performing the signal interaction.

It is to be noted that, the second pads 211 and its corresponding third pad 212 may be provided continuously, that is, there is no partition wall between the second pad 211 and the third pad 212. The second pad 211 and the third pad 212 may also be spaced apart, that is, there is a partition wall between the second pad 211 and the third pad 212.

Here, where the second pad 211 and the third pad 212 are provided continuously, damage to the probe card caused by the partition wall can be avoided when a probe is not aimed during the test, thereby prolonging a service life of the probe card. Meanwhile, generation of impurities may be reduced, thus improving test efficiency. In addition, damage to the partition wall by the probe card is reduced, thus improving the reliability of the package structure as a whole.

When the partition wall is provided between the second pad 211 and the third pad 212, recognition accuracy for each pad by a machine can be improved during the test.

In the following embodiments, the description is given by taking an example that a partition wall is provided between the second pad 211 and the third pad 212, but it is to be understood that, the following description regarding to the partition wall is only used to illustrate the disclosure.

In order to reach a situation that each probe in the probe card can correspond to a corresponding one of the second pads during the second type test, in the embodiments of the disclosure, an offset direction and an offset distance between a center point of a second pad 211 and a center point of a corresponding first pad 205 are same for all the second pads, such that the N first pads and the N second pads keep a same relative position. By doing so, after the first type test, a same set of probe cards can be aligned with center points of all the second pads 211 after moving from center points of the first pads 205 in a certain distance and a certain direction. That is, the second type test can be directly performed with the probe card on all the second pads to be tested without replacing a new probe card.

Meanwhile, the position relationships between the second pad 211 and the third pad 212 at different edges are different; by doing so, the second pads and the third pads can be located near the edges but not beyond the edges. A position setting mode of the first pads and the second pads is specified below through an example.

In some embodiments, the second pad and the third pad included in each of the N redistribution layers are arranged side by side along the second direction, the second direction is perpendicular to the first direction.

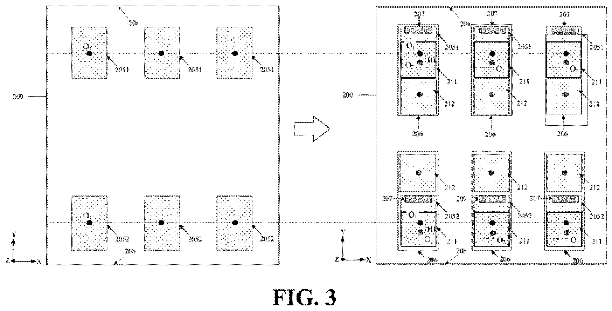

The first pads 205 are arranged at two opposite edges of the semiconductor functional structure. Illustratively, referring to FIG. 3, a left side of the arrow in FIG. 3 shows an example of an arrangement of the first pads 205, which is the same as FIG. 2B and is not repeated here.

Similarly, the N second pads are divided into two parts, namely a third part and a fourth part. The third part includes M1 second pads. The fourth part includes M2 second pads. The M1 second pads in the third part are arranged side by side along the first direction near the first edge of the semiconductor functional structure. The M2 second pads in the fourth part are arranged side by side along the second direction near the second edge of the semiconductor functional structure. Similarly, the N third pads are divided into two parts, namely a fifth part and a sixth part. The fifth part includes M1 third pads. The sixth part includes M2 third pads. The M1 third pads in the fifth part and the M1 second pads are arranged side by side along the second direction near the first edge of the semiconductor functional structure. The M2 third pads in the sixth part and the M2 second pads are arranged side by side along the second direction near the second edge of the semiconductor functional structure.

Illustratively, a right side of the arrow in FIG. 3 shows an example of an arrangement of the redistribution layers 206. Specifically, the six redistribution layers 206 are divided into two parts. Each of the parts includes three redistribution layers, the three redistribution layers 206 in each part are arranged side by side along the X-axis direction, and each of the redistribution layers 206 includes a second pad 211 and a corresponding one of the third pads 212. The second pad 211 and the third pad 212 are arranged side by side along the Y-axis direction. Dotted lines in FIG. 3 show straight lines where the center points of the first pads 205 are located.

In some embodiments, all the first pads 205, the second pads 211 and the third pads 212 are of strip shapes. A shape of an orthographic projection of each of the redistribution layers on a plane where the interconnect layer is located is of a strip shape. A width of each of the first pads 205 along the first direction may be the same as a width of each of the second pads 211 and each of the third pads 212 along the first direction. A length of each of the first pads 205 along the second direction may be different from a length of each of the second pads 211 and each of the third pads 212 along the second direction.

In some embodiments, an orthographic projection of a center point of each of the second pads on the plane where the interconnect layer is located is offset by a first distance along the second direction with respect to a center point of a corresponding first pad.

Illustratively, referring to FIG. 3, at the first edge 20a, the center point O₂ of each of the second pads is offset by the first distance H1 along the Y-axis direction relative to the center point O₁ of the corresponding first pad. Meanwhile, at the second edge 20b, the center point O₂ of each of the second pads is offset by the first distance H1 along the Y-axis direction relative to the center point O₁ of the corresponding first pad.

In some embodiments, first ends of the some first pads near the first edge and second ends of the some redistribution layers near the first edge are substantially flush along a third direction perpendicular to both the first direction and the second direction.

Third ends of the other first pads near the second edge and fourth ends of the other redistribution layers near the second edge are substantially flush along the third direction.

In some embodiments, in the some redistribution layers, second pads are located near the second ends and third pads are located away from the second ends.

In the other redistribution layers, second pads are located near the fourth ends and third pads are located away from the fourth ends.

In some other embodiments, in the some redistribution layers, the third pads are located near the second ends and the second pads are located away from the second ends. In the other redistribution layers, the third pads are located near the fourth ends and the second pads are located away from the fourth ends.

That is to say, on the premise that both an offset direction and an offset distance between a center point of a second pad and a center point of a corresponding first pad are same for all the second pads, the second pad may also be provided at a farther distance from the first pad.

It is to be understood that, where the second pads in the some redistribution layers are located near the second ends, and the second pads in the other redistribution layers are located near the fourth ends, probes move a shorter distance, as compared with the situation where the second pads in the some redistribution layers located away from the second ends and the second pads in the other redistribution layers located near the fourth ends. This can improve test efficiency and reduce a probability of error occurrence. In some embodiments, each of the redistribution layers further includes a first region for conductively connecting with the first pad.

In the some redistribution layers, both the second pad and the third pad located on one same side of the first region. In the other redistribution layers, the second pad and the third pad are respectively located on two sides of the first region.

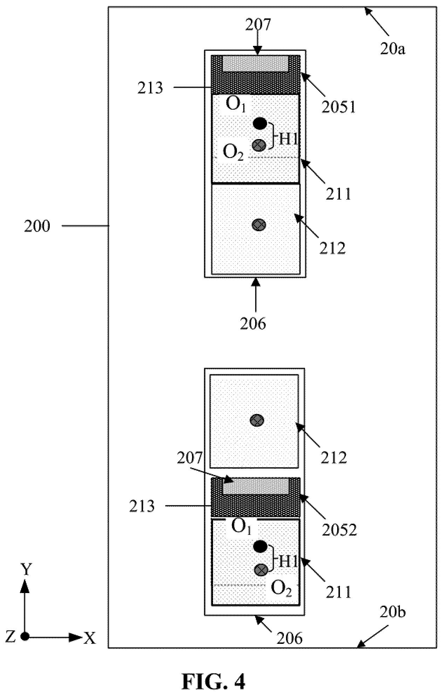

It is to be understood that when the conductive pillar 207 is provided in the package structure, referring to FIG. 3 and FIG. 4, the first region 213 is in contact with the conductive pillar 207 and is located around the conductive pillar, so as to realize electrical connection between each of the first pad and the redistribution layer. When the conductive pillar 207 is not provided in the package structure, the first region 213 is located within the via hole 204. A material of the first region 213 may be the same as or different from the material of the redistribution layer 206 and may be any suitable conductive material.

In the embodiments of the disclosure, the relative position relationships between the second pads and the third pads are different. As shown in FIG. 4, in part of the package structure, the second pad is located between the conductive pillar and the third pad; in another part of the package structure, the conductive pillar 207 is located between the second pad 211 and the third pad 212. Based on this, the first region 213 may be disposed between a corresponding second pad 211 and third pad 212, or may be disposed on a same side of the corresponding second pad 211 and third pad 212.

In addition, it should be understood that when the conductive pillar 207 and/or the first region 213 is disposed between the corresponding second pad 211 and the third pad 212, the partition wall may be provided between the corresponding second pad 211 and third pad 212.

It is to be noted that, in order to more clearly show the relative position relationships among the first pad, the second pad and the third pad, FIG. 4 only shows one redistribution layer near the first edge 20a and one redistribution layer near the second edge 20b. In addition, FIG. 3 and FIG. 4 only schematically show the redistribution layer(s) near the first edge 20a and the corresponding redistribution layer(s) near the second edge 20b, the distance between them does not represent a distance in actual application. The actual distance may be set according to actual needs.

In the embodiments of the disclosure, the positions of the second pad and the third pad are different at different edges. With such a configuration, tests at two different operating speeds can be performed with one same set of probe cards. Compared with a situation that the test are performed with two sets of probe cards, test cost and test time are saved, and production cycle and manufacturing cost are reduced.

According to another aspect of the embodiments of the disclosure, a semiconductor device is provided. The semiconductor device includes a package structure as described in the forgoing embodiments of the disclosure with a semiconductor functional structure.

In some embodiments, the semiconductor device further includes a base plate and a plurality of dies that are stacked. Each of the dies includes a semiconductor functional structure in a package structure. Each of the dies is electrically connected to the base plate through wires on third pads in the package structure.

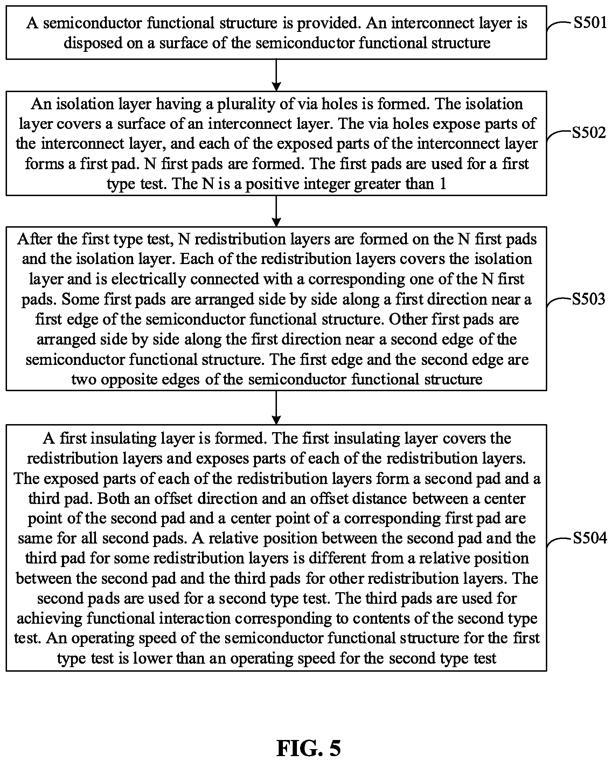

According to yet another aspect of the embodiments of the disclosure, a method for manufacturing a package structure is provided. As shown in FIG. 5, the method includes the following operations.

In S501, a semiconductor functional structure is provided. The top surface of the interconnect layer serves as the top surface of the semiconductor functional structure.

In S502, an isolation layer having a plurality of via holes is formed. The isolation layer covers a surface of the interconnect layer. The via holes expose parts of the interconnect layer, and each of the parts of the interconnect layer exposed by the via holes corresponds to one first pad. N first pads are formed. The first pads are used for performing a first type test. The N is a positive integer greater than 1.

In S503, after the first type test is completed, N redistribution layers are formed on the N first pads and the isolation layer. Each of the redistribution layers covers the isolation layer and is electrically connected with a corresponding one of the N first pads. Some first pads are arranged side by side along a first direction near a first edge of the semiconductor functional structure. Other first pads are arranged side by side along the first direction at positions near a second edge of the semiconductor functional structure. The first edge and the second edge are two opposite edges of the semiconductor functional structure.

In S504, a first insulating layer is formed. The first insulating layer covers the redistribution layers and exposes parts of each of the redistribution layers. The exposed parts of the redistribution layer form a second pad and a third pad. Both an offset direction and an offset distance between a center point of the second pad and a center point of a corresponding first pad are same for all second pads A relative position between the second pads and the third pads in parts of the redistribution layers is different from a relative position between the second pads and the third pads in other parts of the redistribution layers. The second pads are used for performing a second type test. The third pads are used for achieving functional interaction corresponding to a content of the second type test. An operating speed of the semiconductor functional structure for the first type test is lower than an operating speed of the semiconductor functional structure for the second type test.

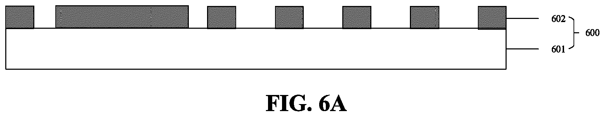

It is to be understood that the operations shown in FIG. 5 are not exclusive and that other operations may be performed before, after, or between any of the operations shown in FIG. 5. The order of the operations shown in FIG. 2 can be adjusted according to actual needs. FIG. 6A to FIG. 6D are cross-sectional schematic diagrams of a process for manufacturing a package structure provided by embodiments of the disclosure. The method for manufacturing the package structure provided by the embodiments of the disclosure will be described in detail with reference to FIG. 5 and FIG. 6A to FIG. 6D.

In S501, referring to FIG. 6A, a semiconductor functional structure 600 is provided, which includes a semiconductor functional layer 601 and a interconnect layer 602. The operation of providing a semiconductor functional structure 600 includes the following operations. A substrate (not shown in FIG. 6A) is provided. A semiconductor functional layer 601 is formed on the substrate. A interconnect layer 602 is formed on the semiconductor functional layer.

Specifically, the semiconductor functional layer 601 includes a single layer thin film or multiple layer thin films. The semiconductor functional layer has a conductive layer and/or a dielectric layer. In the semiconductor functional layer 601, functional structures may be provided according to actual needs. Accordingly, the interconnect layer 602 is used to lead out electrical signals of the functional structures in the semiconductor functional layer 601 to operate the functional structures. In some embodiments, the interconnect layer 602 includes a top metal layer, not only for leading out the electrical signals from the functional structure but also for supporting the semiconductor functional structure 600.

In some embodiments, the method further includes removing part of the interconnect layer 602 to reduce an area of the interconnect layer and reduce a parasitic capacitance generated by the interconnect layer. FIG. 6A is a cross-sectional view of a certain section after the part of the interconnect layer 602 are removed. In practice, the interconnect layer are not truncated, but are interconnected, that is, the interconnect layer may be continuous on other sections.

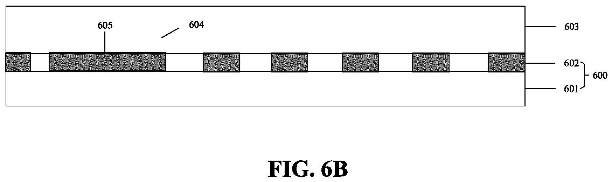

In S502, referring to FIG. 6B, an isolation layer 603 is formed on the interconnect layer 602. A material of the isolation layer includes, but is not limited to, tetraethyl orthosilicate.

Then, parts of the isolation layer are removed to form a plurality of via holes 604. The via holes expose parts of the interconnect layer, and each of the parts exposed by the via holes forms a first pad 605. N first pads 605 are formed. A shape of the via hole 604 may be cylindrical, inverted trapezoidal, or any suitable shape. A cross-sectional area of the via hole includes an area of an orthographic projection of the via hole on the plane where the interconnect layer is located. For example, when the via hole is of an inverted trapezoidal shape, the cross-sectional area of the first pad is the minimum cross-sectional area of the via hole.

The first pads 605 are used to perform a first type test. Also, in an example not forming part of the present invention but useful for understanding it, the first pads 205 can be used to achieve functional interaction corresponding to a content of the first type test, for example, signal interaction and lead out of bonding wires. The first type test may be understood as some tests performed on the semiconductor functional structure at a lower operating speed. It is to be noted that, in a memory, an operating speed refers to a read-write speed of the memory.

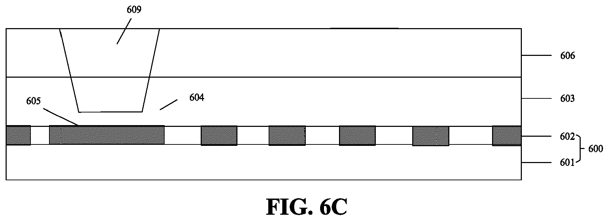

In S503, referring to FIG. 6C, redistribution layers 606 are formed on the isolation layer 603 and in the via holes 604.

A specific manner of forming the redistribution layers 606 on the isolation layer 603 includes the following operations. A new wire pattern is formed on the isolation layer by exposure and development, and then the redistribution layers are formed according to the new wire pattern by using an electroplating technique. The redistribution layers include new wire paths which are electrically connected with the interconnect layer.

Each of the redistribution layers 606 covers the isolation layer 603 and is electrically connected to a corresponding one of the N first pads 605. It is to be noted that, the first pads 605 include first part of the first pads and second part of the first pads. The first pads in the first part of the first pads are arranged side by side along a first direction near a first edge of the semiconductor functional structure. The first pads in the second part of the first pads are arranged side by side along the first direction at positions near a second edge of the semiconductor functional structure. The first edge and the second edge are two opposite edges of the semiconductor functional structure.

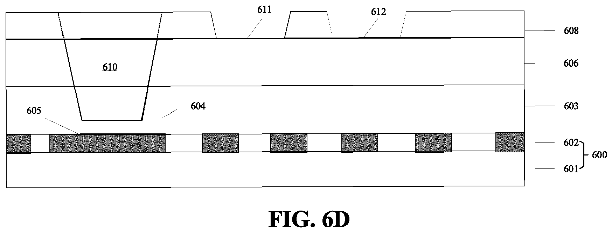

In S504, referring to FIG. 6D, a first insulating layer 608 is formed on the redistribution layers 606.

Then, parts of the first insulating layer 608 are removed to expose parts of the redistribution layer 606. The exposed parts of the redistribution layer form a second pad 611 and a third pad 612. The second pad 611 is used for performing a second type test, and the third pad 612 is used for achieving functional interactions corresponding to a content of the second type test. The second type test may be understood as some tests performed on the semiconductor functional structure at a higher operating speed. The positions of the second pad 611 and the third pad 612 may be selected and set according to actual needs.

It is to be noted that, in the embodiment, referring to FIG. 6D, the first insulating layer not only exposes parts of the redistribution layer to form the second pad and the third redistribution layer, but also exposes another part of the redistribution layer located above the first pad, so as to subsequently fill a second insulating layer 610 in a groove 609 formed by the redistribution layer. A density of the second insulating layer may be less than or equal to that of the first insulating layer. In other embodiments, the first insulating layer also covers a bottom and a sidewall of the groove 609formed by the redistribution layer, and the second insulating layer 610 is subsequently formed in the groove 609 formed by the first insulating layer.

In other embodiments, the package structure also includes a conductive pillar. Accordingly, the method further includes the following operation. The conductive pillar is formed on the first pads after the first type test. The operation that the redistribution layers are formed on the first pads and the isolation layer includes that the redistribution layers are formed on the isolation layer and the conductive pillars. The redistribution layers are electrically connected with the interconnect layer through the conductive pillars.

In the embodiments of the disclosure, the relative position relationship between the second pad and the third pad may be set according to actual needs. For example, the second pad in the package structure is located between the conductive pillar and the third pad, and/or, the conductive pillar in the package structure is located between the second pad 611 and the third pad 612. Based on this, a relative position between the second pad 611 and the third pad 612 in parts of the redistribution layers 606 and a relative position between the second pad 611 and the third pad 612 in other parts of the redistribution layers 606 may be the same or different, which have been described before and are not repeated here.

Both an offset direction and an offset distance between a center point of a second pad and a center point of a corresponding first pad are same for all the second pads. By doing so, after the first type test, a same set of probe cards can be aligned with the center points of all the second pads 211 after moving a certain distance from the center points of the first pads 205 to a certain direction. That is, the second type test can be directly performed by the probe cards on all the second pads without replacing new probe cards.

In addition, in the foregoing embodiments of the disclosure, it is to be noted that a package structure compatible with the two types of tests is adopted, such that a semiconductor functional structure can be subjected to different types of tests at different process stages. However, it should be noted that when designing a layout of the package structure, it is necessary to reserve positions of the via holes of the redistribution layers on the top metal layer, so as to ensure that the top metal layer or any other photomask and process need not be changed when a redistribution layer needs to be added.

In the embodiments provided by the disclosure, it is to be understood that the disclosed apparatus and methods may be implemented in a non-target manner. The embodiments of the device described above are only schematic. For example, the division of the unit is only a logical function division, and there may be another division mode in actual implementation, such as: multiple units or components can be combined, or integrated into another system, or some features can be ignored or not executed, as long as the requirements of the claims are met. In addition, the components shown or discussed are coupled with each other, or directly coupled.

The units described above as separate elements may or may not be physically separated, and the elements displayed as elements may or may not be physical elements, i.e. may be located in one place or may be distributed over multiple network elements. According to the actual needs, some or all of the units can be selected to achieve the purpose of the solutions of the embodiments.

The features disclosed in the several embodiments of methods or devices provided by the disclosure can be arbitrarily combined without conflict, in order to obtain a new embodiment of a method or of a device.

The above-mentioned are only the specific embodiments of the disclosure, and the scope of protection of the disclosure is not limited thereto, but only limited by the appended claims. Within the technical scope of the disclosure, any skilled person familiar with the technical field may easily conceive of changes or substitutions.

### INDUSTRIAL PRACTICALITY

In various embodiments of the disclosure, N first pads are provided in a top metal layer, the first pads are used for a test on the semiconductor functional structure at a first operating speed. Parts of the first pads are arranged side by side along a first direction near a first edge of the semiconductor functional structure. Other parts of the first pads are arranged side by side along the first direction at positions near a second edge of the semiconductor functional structure. After the test at the first operating speed is completed, the second pads corresponding to the first pads one by one are provided in the redistribution layers on the first pads for performing a test on the semiconductor functional structure at a second operating speed. A relative position between the second pads and the third pads in parts of the redistribution layers is different from a relative position between the second pads and the third pads in other parts of the redistribution layers. Both an offset direction and an offset distance between a center point of a second pad and a center point of a corresponding first pad are same for all the second pads. By doing so, a first pad and the corresponding second pad keeps a same relative position for all the N first pads and N second pads. Meanwhile, relative positions between the second pad and the third pad located at different edges are different. By doing so, the redistribution layers located at the two edges can keep a large fault tolerance rate, and can all be close to the edge but not beyond the edge. Therefore, the first pads and the second pads are ensured to be in favorable positions which are beneficial to saving a total area, and meanwhile, a same set of probe cards may be used for tests at the two different operating speeds. Compared with using two sets of probe cards to test separately, test cost and time are saved, and production cycle and manufacturing cost are reduced.

## Claims

1. A package structure comprising a semiconductor functional structure (200, 600), wherein the semiconductor functional structure (200, 600) comprises a semiconductor functional layer (201, 601) and an interconnect layer (202, 602), and the top surface of the interconnect layer (202, 602) serves as the top surface of the semiconductor functional structure (200, 600), the package structure further comprising:
an isolation layer (203, 603) having N via holes (204, 604), wherein the isolation layer (203, 603) covers a surface of the interconnect layer (202, 602), and the via holes (204, 604) expose parts of the interconnect layer (202, 602);
N first pads (205, 605), wherein each of the first pads (205, 605) is formed by the interconnect layer (202, 602) exposed by one of the via holes (204, 604), and N is a positive integer greater than 1;
N redistribution layers (206, 606) on the N first pads (205, 605), wherein each of the redistribution layers (206, 606) of the N redistribution layers (206, 606) covers the isolation layer (203, 603) and is electrically connected with a corresponding one of the N first pads (205, 605), some first pads are arranged side by side along a first direction near a first edge of the semiconductor functional structure (200, 600), other first pads are arranged side by side along the first direction near a second edge of the semiconductor functional structure (200, 600), the first edge and the second edge are two opposite edges of the semiconductor functional structure (200, 600);
a first insulating layer (208, 608) covering the redistribution layers (206, 606) and exposing parts of each of the redistribution layers (206, 606); and
second pads (211, 611) and third pads (212, 612), wherein the exposed parts of each of the redistribution layers (206, 606) form a second pad (211, 611) and a third pad (212, 612), both an offset direction and an offset distance between a center point of the second pad (211, 611) and a center point of a corresponding first pad (205, 605) are the same for all the second pads (211, 611), a relative position between the second pad (211, 611) and the third pad (212, 612) for some of the redistribution layers is different from a relative position between the second pad (211, 611) and the third pad (212, 612) for other redistribution layers; the first pads (205, 605) and the second pads (211, 611) are used for testing the semiconductor functional structure (200, 600) at different operating speeds, and the third pads (212, 612) are used for achieving functional interaction corresponding to contents tested by the second pads (211, 611).

2. The package structure of claim 1, wherein the second pad (211, 611) and the third pad (212, 612) comprised in each of the N redistribution layers (206, 606) are arranged side by side along a second direction, the second direction is perpendicular to the first direction.

3. The package structure of claim 2, wherein an orthographic projection of the center point of each of the second pads (211, 611) on a plane where the interconnect layer (202, 602) is located is offset by a first distance along the second direction with respect to the center point of the corresponding first pad (205, 605).

4. The package structure of claim 3, wherein an orthographic projection of each of the redistribution layers (206, 606) on the plane where the interconnect layer (202, 602) is located is of a strip shape.

5. The package structure of claim 4,
wherein first ends of the some of the first pads (205, 605) near the first edge and second ends of the some of the redistribution layers (206, 606) near the first edge are substantially flush along a third direction perpendicular to both the first direction and the second direction; and
wherein third ends of the other first pads (205, 605) near the second edge and fourth ends of the other redistribution layers (206, 606) near the second edge are substantially flush along the third direction.

6. The package structure of claim 5,
wherein in the some of the redistribution layers (206, 606), the second pads (211, 611) are located near the second ends and the third pads (212, 612) are located away from the second ends; and
wherein in the other redistribution layers (206, 606), the second pads (211, 611) are located near the fourth ends and the third pads (212, 612) are located away from the fourth ends.

7. The package structure of claim 6,
wherein each redistribution layer (206, 606) further comprises a first region (213) for conductively connecting with the corresponding first pad (205, 605); and
wherein in the some of redistribution layers (206, 606), the second pads (211, 611) and the third pads (212, 612) are located at one side of first regions (213); and in the other redistribution layers (206, 606), the second pads (211, 611) and the third pads (212, 612) respectively located at two sides of the first regions (213).

8. The package structure of claim 1,
wherein each redistribution layer (206, 606) contacts with the corresponding first pad (205, 605) directly; or
wherein the package structure further comprises conductive pillars (207), wherein the corresponding conductive pillar (207) is located between the corresponding redistribution layer (206, 606) and the corresponding first pad (205, 605), and the redistribution layer (206, 606) is electrically connected with the interconnect layer (202, 602) through the conductive pillar (207).

9. The package structure of claim 8, wherein the package structure comprises the plurality of conductive pillars (207), and the plurality of conductive pillars (207) are arranged side by side along the first direction.

10. The package structure of claim 8, wherein each redistribution layer (206, 606) contacts with the corresponding first pad (205, 605) directly, and the package structure further comprises:
second insulating layers (210, 610) located within grooves (209, 609), wherein each of the grooves (209, 609) is surrounded by the corresponding redistribution layer (206, 606), a hardness of a material of the second insulating layers (210, 610) is less than a hardness of a material of the redistribution layers (206, 606).

11. A semiconductor device, **characterized in that** the semiconductor device comprises the package structure according to any one of claims 1 to 10.

12. The semiconductor device of claim 11, further comprising:
a base plate; and
a plurality of dies that are stacked, wherein each of the dies comprises the package structure,
wherein each of the dies is electrically connected to the base plate through wires on the third pads (212, 612) in the package structure.

13. A method for manufacturing a package structure according to claim 1, the package structure comprising a semiconductor functional structure (200, 600), wherein the semiconductor functional structure (200, 600) comprises a semiconductor functional layer (201, 601) and an interconnect layer (202, 602), and the top surface of the interconnect layer (202, 602) serves as the top surface of the semiconductor functional structure (200, 600), the method comprising:
forming an isolation layer (203, 603) having N via holes (204, 604), wherein the isolation layer (203, 603) covers a surface of the interconnect layer (202, 602), the via holes (204, 604) expose parts of the interconnect layer (202, 602), and each of the exposed parts of the interconnect layer (202, 602) forms a first pad (205, 605), N first pads (205, 605) are formed; the first pads (205, 605) are used for a first type test, and the N is a positive integer greater than 1;
forming N redistribution layers (206, 606) on the N first pads (205, 605) and the isolation layer (203, 603) after the first type test, wherein each of the redistribution layers (206, 606) covers the isolation layer (203, 603) and is electrically connected with a corresponding one of the N first pads (205, 605), some of the first pads (205, 605) are arranged side by side along a first direction near a first edge of the semiconductor functional structure (200, 600), other first pads are arranged side by side along the first direction near a second edge of the semiconductor functional structure (200, 600), and the first edge and the second edge are two opposite edges of the semiconductor functional structure (200, 600); and
forming a first insulating layer (208, 608) covering the redistribution layers (206, 606) and exposing parts of each of the redistribution layers (206, 606), wherein the exposed parts of each of the redistribution layers (206, 606) form a second pad (211, 611) and a third pad (212, 612); both an offset direction and an offset distance between a center point of the second pad (211, 611) and a center point of a corresponding first pad (205, 605) are same for all second pads (211, 611); a relative position between the second pad (211, 611) and the third pads (212, 612) for some of the redistribution layers is different from a relative position between the second pad (211, 611) and the third pad (212, 612) for other redistribution layers; the second pads (211, 611) are used for a second type test, third pads (212, 612) are used for performing functional interaction corresponding to contents of the second type test; and an operating speed of the semiconductor functional structure (200, 600) for the first type test is lower than an operating speed for the second type test.

## Patentansprüche

1. Gehäusestruktur, umfassend
eine funktionelle Halbleiterstruktur (200, 600),
wobei die
funktionelle Halbleiterstruktur (200, 600) eine funktionelle Halbleiterstruktur (201, 601) und eine Verbindungsschicht (202, 602) umfasst, und die obere
Oberfläche der Verbindungsschicht (202, 602) als obere Oberfläche der funktionellen Halbleiterstruktur (200, 600) dient, wobei die Gehäusestruktur ferner
Folgendes umfasst:
eine Isolierschicht (203, 603), die N Durchgangslöcher (204, 604) aufweist, wobei die Isolierschicht (203, 603) eine Oberfläche der Verbindungsschicht (202, 602) bedeckt, und
die Durchgangslöcher (204, 604)
Teile der Verbindungsschicht (202, 602) freilegen;
N erste Kontaktflächen (205, 605), wobei jede der ersten Kontaktflächen (205, 605) durch die Verbindungsschicht (202, 602) gebildet ist, die durch eines der Durchgangslöcher (204, 604) freigelegt ist, und
N ist eine positive
eine ganze Zahl größer als 1 ist.
N-Umverteilungsschichten (206, 606) auf den N ersten Kontaktflächen (205, 605),
wobei jede der Umverteilungsschichten (206, 606)
der N-Umverteilungsschichten (206, 606)
die Isolierschicht (203, 603) bedeckt
und elektrisch mit einem entsprechenden der N ersten Kontaktflächen (205, 605) verbunden ist, einige erste Kontaktflächen nebeneinander entlang einer ersten Richtung in der Nähe eines ersten Randes der funktionellen Halbleiterstruktur (200, 600) angeordnet sind, andere erste Kontaktflächen nebeneinander entlang der ersten Richtung in der Nähe eines zweiten Rands der funktionellen Halbleiterstruktur (200, 600) angeordnet sind, der erste Rand und der zweite Rand zwei gegenüberliegende Ränder der funktionellen Halbleiterstruktur (200, 600) sind;
eine erste Isolierschicht (208, 608), die die Umverteilungsschichten (206, 606) bedeckt
und
Teile jeder der Umverteilungsschichten (206, 606) freilegt;
und
zweite Kontaktflächen (211, 611) und dritte Kontaktflächen (212, 612), wobei die freiliegenden Teile jeder der Umverteilungsschichten (206, 606)
eine zweite Kontaktfläche (211, 611) und eine dritte Kontaktfläche (212,
612) bilden, wobei sowohl eine Versatzrichtung als auch ein Versatzabstand zwischen einem Mittelpunkt der zweiten Kontaktfläche (211, 611) und einem Mittelpunkt einer entsprechenden ersten Kontaktfläche (205, 605)
für alle
zweiten Kontaktflächen (211, 611) gleich sind, eine relative Position zwischen der zweiten Kontaktfläche (211, 611) und der dritten Kontaktfläche (212, 612) für einige der Umverteilungsschichten von einer relativen Position zwischen der zweiten Kontaktfläche (211, 611) und der dritten Kontaktfläche (212, 612) für andere Umverteilungsschichten verschieden ist; die ersten Kontaktflächen (205, 605) und die zweiten Kontaktflächen (211, 611) zum Testen der funktionellen Halbleiterstruktur (200, 600) bei unterschiedlichen Betriebsgeschwindigkeiten verwendet werden, und die dritten Kontaktflächen (212, 612) zum Erreichen einer funktionellen Interaktion verwendet werden, die den von den zweiten Kontaktflächen (211, 611) getesteten Inhalten entspricht.

2. Gehäusestruktur nach Anspruch 1, wobei die zweiten Kontaktflächen (211, 611) und die dritten Kontaktflächen (212,
612), die in jeder der N-Umverteilungsschichten (206, 606) enthalten sind,
Seite an Seite
entlang einer zweiten Richtung angeordnet sind, wobei die zweite Richtung senkrecht zu der ersten Richtung ist.

3. Gehäusestruktur nach Anspruch 2, wobei eine orthografische Projektion des Mittelpunkts von
jeder der zweiten Kontaktfläche
(211, 611) auf einer Ebene, auf der sich die Verbindungsschicht (202, 602) befindet, um einen ersten Abstand entlang der zweiten Richtung in Bezug auf den Mittelpunkt der entsprechenden ersten Kontaktfläche (205, 605) versetzt ist.

4. Gehäusestruktur nach Anspruch 3, wobei eine orthografische Projektion jeder der Umverteilungsschichten (206, 606)
auf der Ebene, auf der sich die Verbindungsschicht (202, 602) befindet,
von der Form eines Streifens ist.

5. Gehäusestruktur nach Anspruch 4,
wobei die ersten Enden einiger der ersten Kontaktflächen (205, 605) in der Nähe des ersten Rands und zweite Enden von
einigen der Umverteilungsschichten (206, 606)
in der Nähe des ersten Rands im Wesentlichen bündig entlang einer dritten Richtung senkrecht zu der ersten und der zweiten Richtung sind; und
wobei dritte Enden der anderen ersten Kontaktflächen (205, 605) in der Nähe des zweiten Rands und vierte Enden der
anderen Umverteilungsschichten (206, 606)
in der Nähe des zweiten Rands entlang der dritten Richtung im Wesentlichen bündig sind.

6. Gehäusestruktur nach Anspruch 5,
wobei sich in einigen der Umverteilungsschichten (206, 606)
die zweiten Kontaktflächen (211, 611)
in der Nähe der zweiten Enden befinden und sich die dritten Kontaktflächen (212, 612) entfernt von den zweiten Enden befinden; und
wobei sich in den anderen Umverteilungsschichten (206, 606),
die zweiten Kontaktflächen (211, 611) in der Nähe
der vierten Enden befinden und sich die dritten Kontaktflächen (212, 612) entfernt von den vierten Enden befinden.

7. Gehäusestruktur nach Anspruch 6,
wobei jede Umverteilungsschicht (206, 606)
ferner einen ersten Bereich (213)
zum leitenden Verbinden mit der entsprechenden ersten Kontaktfläche (205, 605) umfasst; und
wobei sich in einigen der Umverteilungsschichten (206, 606)
die zweiten Kontaktflächen (211, 611) und die dritten
Kontaktflächen (212, 612) auf einer Seite der ersten Bereiche (213) befinden, und sich in den anderen Umverteilungsschichten (206, 606)
die zweiten Kontaktflächen (211, 611) und die dritten Kontaktflächen (212, 612) jeweils an zwei Seiten der ersten Bereiche (213) befinden.

8. Gehäusestruktur nach Anspruch 1,
wobei jede Umverteilungsschicht (206, 606)
die entsprechende erste
Kontaktfläche (205, 605) direkt berührt; oder
wobei die Gehäusestruktur außerdem leitende Säulen
(207) umfasst, wobei sich die
Die entsprechende leitende Säule (207) zwischen der entsprechenden Umverteilungsschicht (206, 606) und der
entsprechende erste Kontaktfläche (205, 605) befindet und die Umverteilungsschicht (206, 606)
elektrisch
über die leitende Säule (207) mit der Verbindungsschicht (202, 602) verbunden ist.

9. Gehäusestruktur nach Anspruch 8, wobei die Gehäusestruktur die
Vielzahl von leitenden Säulen (207) umfasst, und die Vielzahl von leitenden Säulen (207) nebeneinander entlang der ersten Richtung angeordnet sind.

10. Gehäusestruktur nach Anspruch 8, wobei jede Umverteilungsschicht (206, 606)
die entsprechende erste Kontaktfläche (205, 605) direkt berührt, und die Gehäusestruktur Ferner Folgendes umfasst:
zweite Isolierschichten (210, 610), die sich in Rillen (209, 609) befinden, wobei jede der Rillen (209, 609) von der entsprechenden Umverteilungsschicht (206, 606) umgeben ist,
eine Härte
eines Materials der zweiten Isolierschichten (210, 610) geringer ist als eine Härte eines Materials der Umverteilungsschichten (206, 606).

11. Halbleitervorrichtung, **dadurch gekennzeichnet, dass** die Halbleitervorrichtung die Gehäusestruktur nach einem der Ansprüche 1 bis 10 umfasst.

12. Halbleiterstruktur nach Anspruch 11, ferner umfassend:
eine Grundplatte; und
eine Vielzahl von übereinander gestapelten Matrizen, wobei jede der Matrizen die Gehäusestruktur umfasst,
wobei jede der Matrizen über Drähte an den dritten Kontaktflächen (212, 612) in der Gehäusestruktur elektrisch mit der Grundplatte verbunden ist.

13. Verfahren zur Herstellung einer Gehäusestruktur nach Anspruch 1, die Gehäusestruktur umfassend
eine funktionelle Halbleiterstruktur (200, 600),
wobei die funktionelle Halbleiterstruktur (200, 600)
eine funktionelle Halbleiterstruktur (201, 601) und eine
Verbindungsschicht (202, 602) umfasst, und die obere Oberfläche der Verbindungsschicht (202, 602) als die obere Oberfläche der funktionellen Halbleiterstruktur (200, 600) dient, das Verfahren umfassend:
Bilden einer Isolierschicht (203, 603),
die N Durchgangslöcher (204, 604) aufweist, wobei die Isolierschicht (203, 603)
eine Oberfläche der Verbindungsschicht (202, 602) bedeckt, die Durchgangslöcher (204, 604) Teile der Verbindungsschicht (202, 602) freilegen und jeder der freigelegten Teile der Verbindungsschicht (202, 602) eine erste Kontaktfläche (205, 605) bildet, N erste Kontaktflächen (205, 605) gebildet werden; die ersten Kontaktflächen (205, 605) für eine erste Typprüfung verwendet werden und das N eine positive ganze Zahl größer als 1 ist;
Bilden von N-Umverteilungsschichten (206, 606) auf den N ersten Kontaktflächen (205, 605) und der Isolierschicht (203, 603) nach der ersten Typprüfung, wobei jede der Umverteilungsschichten (206, 606)
die Isolierschicht (203, 603) bedeckt und elektrisch mit einer entsprechenden der N ersten Kontaktflächen (205, 605) verbunden ist, wobei einige der ersten Kontaktflächen (205, 605) nebeneinander
entlang einer ersten Richtung in der Nähe einer ersten Kante der funktionellen Halbleiterstruktur (200, 600) angeordnet sind, andere erste Kontaktflächen nebeneinander entlang der ersten Richtung in der Nähe einer zweiten Kante der funktionellen Halbleiterstruktur (200, 600) angeordnet sind und der erste Rand und der zweite Rand zwei gegenüberliegende Ränder der funktionellen Halbleiterstruktur (200, 600) sind; und
Bilden einer ersten Isolierschicht (208, 608), die die Umverteilungsschichten (206, 606) bedeckt
und Teile von jeder der Umverteilungsschichten (206, 606) freilegt,
wobei die freiliegenden Teile jeder der Umverteilungsschichten (206, 606)
eine zweite Kontaktfläche (211, 611) und eine dritte Kontaktfläche (212, 612) bilden; sowohl eine Versatzrichtung als auch ein Versatzabstand zwischen einem Mittelpunkt der zweiten Kontaktfläche (211, 611) und einem Mittelpunkt einer entsprechenden ersten Kontaktfläche (205, 605) für alle zweiten Kontaktflächen (211, 611) gleich sind; eine relative Position zwischen der zweiten Kontaktfläche (211, 611) und der dritten Kontaktflächen (212, 612) für einige der Umverteilungsschichten sich von einer relativen Position zwischen der zweiten Kontaktfläche (211, 611) und der dritten Kontaktfläche (212, 612) für andere Umverteilungsschichten unterscheidet; die zweiten Kontaktflächen (211, 611) für eine zweite Typprüfung verwendet werden, dritte Kontaktflächen (212, 612) für die Durchführung einer funktionellen Interaktion verwendet werden, die dem Inhalt der zweiten Typprüfung entspricht; und eine Betriebsgeschwindigkeit der funktionellen Halbleiterstruktur (200, 600) für die erste Typprüfung niedriger ist als eine Betriebsgeschwindigkeit für die zweite Typprüfung.

## Revendications

1. Structure d'encapsulation comprenant
une structure fonctionnelle semi-conductrice (200, 600),
dans laquelle la
la structure fonctionnelle semi-conductrice (200, 600) comprend une couche fonctionnelle semi-conductrice (201, 601) et une couche d'interconnexion (202, 602), et la surface supérieure de la couche d'interconnexion (202, 602) sert de surface supérieure de la structure fonctionnelle semi-conductrice (200, 600), la structure d'encapsulation comprenant
en outre :
une couche d'isolation (203, 603) comportant N trous d'interconnexion (204, 604), dans laquelle la couche d'isolation (203, 603) recouvre une surface de la couche d'interconnexion (202, 602), et
les trous d'interconnexion (204, 604)
exposent des parties de la couche d'interconnexion (202, 602) ;
N premiers revêtements (205, 605), dans laquelle chacun des premiers revêtements (205, 605) est formé par la couche d'interconnexion (202, 602) exposée par l'un des trous d'interconnexion (204, 604), et
N est un nombre entier
positif supérieur à 1 ;
N couches de redistribution (206, 606) sur les N premiers revêtements (205, 605),
dans laquelle chacune des couches de redistribution (206, 606)
des N couches de redistribution (206, 606)
recouvre la couche d'isolation (203, 603)
et est connectée électriquement à un revêtement correspondant des N premiers revêtements (205, 605), certains premiers revêtements sont disposés côte à côte le long d'une première direction près d'un premier bord de la structure fonctionnelle semi-conductrice (200, 600), d'autres premiers revêtements sont disposés côte à côte le long de la première direction près d'un second bord de la structure fonctionnelle semi-conductrice (200, 600), le premier bord et le second bord sont deux bords opposés de la structure fonctionnelle semi-conductrice (200, 600) ;
une première couche isolante (208, 608) recouvrant les couches de redistribution (206, 606)
et
exposant des parties de chacune des couches de redistribution (206, 606) ;
et
de deuxièmes revêtements (211, 611) et de troisièmes revêtements (212, 612), dans laquelle les parties exposées de chacune des couches de redistribution (206, 606)
forment un deuxième revêtement (211, 611) et un troisième revêtement (212,
612), une direction de décalage et une distance de décalage entre un point central du deuxième revêtement (211, 611) et un point central d'un premier revêtement (205, 605) correspondant sont toutes deux les
mêmes pour tous les
les deuxièmes revêtements (211, 611), une position relative entre le deuxième revêtement (211, 611) et le troisième revêtement (212, 612) pour certaines des couches de redistribution est différente d'une position relative entre le deuxième revêtement (211, 611) et le troisième revêtement (212, 612) pour d'autres couches de redistribution ; les premiers revêtements (205, 605) et les deuxièmes revêtements (211, 611) sont utilisés pour tester la structure fonctionnelle semi-conductrice (200, 600) à différentes vitesses de fonctionnement, et les troisièmes revêtements (212, 612) sont utilisés pour obtenir une interaction fonctionnelle correspondant au contenu testé par les deuxièmes revêtements (211, 611).

2. Structure d'encapsulation selon la revendication 1, dans laquelle le deuxième revêtement (211, 611) et le troisième revêtement (212,
612) compris dans chacune des N couches de redistribution (206, 606)
sont disposés côte à côte
le long d'une deuxième direction, la deuxième direction étant perpendiculaire à la première.

3. Structure d'encapsulation selon la revendication 2, dans laquelle une projection orthographique du point central de
chacun des deuxièmes revêtements
(211, 611) sur un plan où se trouve la couche d'interconnexion (202, 602) est décalé d'une première distance le long de la deuxième direction par rapport au point central du premier revêtement (205, 605) correspondant.

4. Structure d'encapsulation selon la revendication 3, dans laquelle une projection orthographique de chacune des
couches de redistribution (206, 606)
sur le plan où se trouve la couche d'interconnexion (202, 602) est en forme de bande.

5. Structure d'encapsulation selon la revendication 4,
dans laquelle les premières extrémités de certains des premiers revêtements (205, 605) à proximité du premier bord et les secondes extrémités de
certaines des couches de redistribution (206, 606)
à proximité du premier bord sont sensiblement alignées le long d'une troisième direction perpendiculaire à la fois à la première direction et à la deuxième direction ; et
dans laquelle les troisièmes extrémités des autres premiers revêtements (205, 605) à proximité du deuxième bord et les quatrièmes extrémités des
autres couches de redistribution (206, 606)
à proximité du deuxième bord sont sensiblement alignées le long de la troisième direction.

6. Structure d'encapsulation selon la revendication 5,
dans laquelle dans certaines des couches de redistribution (206, 606),
les deuxièmes revêtements (211, 611) sont situés
à proximité des deuxièmes extrémités et les troisièmes revêtements (212, 612) sont situés loin des deuxièmes extrémités ; et
dans laquelle dans les autres couches de redistribution (206, 606),
les deuxièmes revêtements (211, 611) sont situés à proximité des quatrièmes extrémités et les troisièmes revêtements (212, 612) sont situés loin des quatrièmes extrémités.

7. Structure d'encapsulation selon la revendication 6,
dans laquelle chaque couche de redistribution (206, 606)
comprend en outre une première région (213)
destinée à se connecter de manière conductrice au premier revêtement (205, 605) correspondant ; et
dans laquelle dans certaines des couches de redistribution (206, 606),
les deuxièmes revêtements (211, 611) et les troisièmes
revêtements (212, 612) sont situés d'un côté des premières régions (213) et dans les autres couches de redistribution (206, 606),
les deuxièmes revêtements (211, 611) et les troisièmes revêtements (212, 612) sont situés respectivement de part et d'autre des premières régions (213).

8. Structure d'encapsulation selon la revendication 1,
dans laquelle chaque couche de redistribution (206, 606)
est directement en contact avec le premier revêtement (205, 605) correspondant ; ou
dans laquelle la structure d'encapsulation comprend en outre des piliers conducteurs
(207), dans laquelle le
pilier conducteur (207) correspondant est situé entre la couche de redistribution (206, 606) correspondante et le
le premier revêtement (205, 605) correspondant, et la couche de redistribution (206, 606) est connectée
électriquement à la couche d'interconnexion (202, 602) par l'intermédiaire du pilier conducteur (207).

9. Structure d'encapsulation selon la revendication 8, dans laquelle la structure d'encapsulation comprend la
pluralité de piliers conducteurs (207), et la pluralité de piliers conducteurs (207) sont disposés côte à côte le long de la première direction.

10. Structure d'encapsulation selon la revendication 8, dans laquelle chaque couche de redistribution (206, 606) est directement en contact
avec le premier revêtement (205, 605) correspondant, et la structure d'encapsulation comprend en outre :
de secondes couches isolantes (210, 610) situées dans des rainures (209, 609), dans laquelle chacune des rainures (209, 609) est entourée de la couche de redistribution correspondante (206, 606),
une dureté d'un
matériau des secondes couches isolantes (210, 610) est inférieure à une dureté d'un matériau des couches de redistribution (206, 606).

11. Dispositif semi-conducteur, **caractérisé en ce que** le dispositif semi-conducteur comprend la
structure d'encapsulation selon l'une quelconque des revendications 1 à 10.

12. Dispositif semi-conducteur selon la revendication 11, comprenant en outre :
une plaque de base ; et
une pluralité de matrices qui sont empilées, dans laquelle chacune des matrices comprend la structure d'encapsulation,
dans laquelle chaque matrice est connectée électriquement à la plaque de base par des fils situés sur les troisièmes revêtements (212, 612) de la structure d'encapsulation.

13. Procédé de fabrication d'une structure d'encapsulation selon la revendication 1, la structure d'encapsulation comprenant une
structure fonctionnelle semi-conductrice (200, 600),
dans lequel la structure fonctionnelle semi-conductrice (200, 600) comprend
une couche fonctionnelle semi-conductrice (201, 601) et une
couche d'interconnexion (202, 602), et la surface supérieure de la couche d'interconnexion (202, 602) sert de surface supérieure de la structure fonctionnelle semi-conductrice (200, 600), le procédé comprenant :
la formation d'une couche d'isolation (203, 603)
comportant N trous d'interconnexion (204, 604), dans lequel la couche d'isolation (203, 603)
recouvre une surface de la couche d'interconnexion (202, 602), les trous d'interconnexion (204, 604) exposent des parties de la couche d'interconnexion (202, 602), et chacune des parties exposées de la couche d'interconnexion (202, 602) forme un premier revêtement (205, 605), N premiers revêtements (205, 605) sont formés ; les premiers revêtements (205, 605) sont utilisés pour un premier essai de type, et N est un nombre entier positif supérieur à 1 ;
la formation de N couches de redistribution (206, 606)
sur les N premiers revêtements (205, 605) et la couche d'isolation (203, 603) après le premier essai de type, dans lequel chacune des couches de redistribution
(206, 606)
recouvre la couche d'isolation (203, 603) et est connectée électriquement à un revêtement correspondant des N premiers revêtements (205, 605) correspondantes, certains des premiers revêtements (205, 605)
sont disposés côte à côte
le long d'une première direction près d'un premier bord de la structure fonctionnelle semi-conductrice (200, 600), d'autres premiers revêtements sont disposés côte à côte le long de la première direction près d'un second bord de la structure fonctionnelle semi-conductrice (200, 600), et le premier bord et le second bord sont deux bords opposés de la structure fonctionnelle semi-conductrice (200, 600) ; et
la formation d'une première couche isolante (208, 608) recouvrant les couches de redistribution (206, 606)
et exposant des parties de chacune des couches de redistribution (206, 606),
dans lequel
les parties exposées de chacune des couches de redistribution (206, 606)
forment un deuxième revêtement (211,
611) et un troisième revêtement (212, 612) ; une direction de décalage et une distance de décalage entre un point central du deuxième revêtement (211, 611) et un point central d'un premier revêtement (205, 605) correspondant sont identiques pour tous les deuxièmes revêtements (211, 611) ; une position relative entre le deuxième revêtement (211, 611) et les troisièmes revêtements (212, 612) pour certaines des couches de redistribution est différente d'une position relative entre le deuxième revêtement (211, 611) et les troisièmes revêtements (212, 612) pour d'autres couches de redistribution ; les deuxièmes revêtements (211, 611) sont utilisés pour un second essai de type, les troisièmes revêtements (212, 612) sont utilisés pour effectuer une interaction fonctionnelle correspondant au contenu du second essai de type ; et une vitesse de fonctionnement de la structure fonctionnelle semi-conductrice (200, 600) pour le premier essai de type est inférieure à une vitesse de fonctionnement pour le second essai de type.
